# EUROPÄISCHE PATENTSCHRIFT

(11) **EP 1 577 150 B1**
(45) Veröffentlichungstag und Bekanntmachung des Hinweises auf die Patenterteilung: **05.10.2005**
(21) Anmeldenummer: 04005599.8
(22) Anmeldetag: 09.03.2004
(51) Int. Cl.: B60M 3/00

(54) **Verfahren zur Erkennung von Kurzschlüssen auf ausgeschalteten Leitungsabzweigen von elektrischen Wechsel- oder Drehstromnetzen, insbesondere auf Leitungsabzweigen zur Versorgung von Eisenbahnstrecken**
Arrangement for detecting short-circuits in switched-off branches of electrical AC power networks, especially in branches for feeding railways
Dispositif pour la détection de court-circuits dans des lignes d' alimentation de courant alternatif déconnectées, en particulier dans des lignes pour alimentation électrique de reseaux ferroviaires

(43) Veröffentlichungstag der Anmeldung: 21.09.2005
(73) Patentinhaber: Va Tech Sat GmbH & Co, 1210 Wien (AT)
(72) Erfinder: Stollberg, Andreas, 99986 Oberdorla (DE)
(74) Vertreter: Grünecker, Kinkeldey, Stockmair & Schwanhäusser Anwaltssozietät

(56) Entgegenhaltungen:
- EP-A- 0 555 946
- EP-A- 0 563 695

## Beschreibung

Die vorliegende Erfindung bezieht sich auf ein Verfahren zur Erkennung von Kurzschlüssen auf ausgeschalteten Leitungsabzweigen von elektrischen Wechsel- oder Drehstromnetzen insbesondere auf Leitungsabzweigen zur Versorgung von Eisenbahnstrecken.

Elektrifizierte Eisenbahnstrecken sind in einzelne Speiseabschnitte unterteilt, die jeweils auf einen etwa auftretenden Kurzschluss an den Einspeisestellen (Leitungsabzweigen) überwacht werden. Im Kurzschlussfall wird der Leitungsabzweig abgeschaltet und anschließend daraufhin überprüft, ob es sich um einen dauerhaften Kurzschluss handelt, oder ob es nur ein so genannter "Kurzschlusswischer" war. Kurzschlusswischer entstehen beispielsweise durch Überschläge infolge Unterschreitung des Sicherheitsabstandes zu spannungsführenden Teilen, Überschläge an den Isolatoren bei Nebel, Gewitter, durch Vögel, in die Oberleitung gewehte Äste, Planen und sonstige Fremdkörper, schadhafter oder stark verschmutzter Isolatoren und defekte Stromabnehmer von elektrischen Triebfahrzeugen. Derartige Kurzschlusswischer sind einmalige Ereignisse, die durch Abbrand quasi "selbstheilend" sind und es erlauben, den vollen Netzbetrieb wiederaufzunehmen. Dauerkurzschlüsse entstehen beispielsweise, wenn gerissene, spannungsführende Teile der Oberleitung auf Fahrzeugen, Schienen oder erdbodenfest aufliegen, leitende Gegenstände Isolatoren überbrücken, elektrische Triebfahrzeuge mit schadhafter Hochspannungsdachausrüstung liegen bleiben oder dauerhafte, niederohmige Erdverbindungen zur Oberleitung geschaffen worden sind.

Um diese beiden Arten von Oberleitungskurzschlüssen zu unterscheiden, ist in den Bahnstromschaltanlagen jeweils eine Prüfzelle, eine separate 15-kV-Prüfschiene und eine Oberleitungsprüfautomatik (OLPA) installiert.

Durch die Schutzauslösung des Leistungsschalters wird die OLPA angeregt und beginnt mit der Durchführung ihres Prüfprogramms.

Bei den älteren Schaltanlagen sowie in einigen Regionen auch bei Neubau üblich erfolgt die Anspeisung der Prüfschiene von der 15-kV-Betriebsschiene über den sogenannten Werkumspanner, der 230-Volt-Eigenbedarfschiene, dem Niederspannungsprüfwiderstand und dem Prüfumspanner. Der Prüfumspanner ist nicht ständig in Betrieb; nur zu Prüfzwecken schaltet hier die OLPA vorher zusätzlich den Niederspannungs-Leistungsschalter des Prüfumspanners ein, und nach erfolgter Prüfung wieder aus. Bei den neueren deutschen Normschaltanlagen werden die Prüfschienen ständig durch einen Hochspannungs-Prüfwiderstand mit 3,3 kOhm von der 15-kV-Betriebsschiene aus unter Spannung gesetzt.

Alle elektrischen Triebfahrzeuge, die sich gerade in einem Oberleitungsspeiseabschnitt befinden, welcher durch Kurzschluss- oder Überlastauslösung des Oberleitungs-Leistungsschalters spannungslos geworden ist, erhalten automatisch eine Ausschaltung des Lokhauptschalters durch ein im Fahrzeug eingebautes Unterspannungsrelais. Ebenso müssen alle leistungsstarken elektrischen Nebenverbraucher, die an der Oberleitung angeschlossen sind und von dort mit Energie versorgt werden, wie z.B. Weichenheizungen und Vorheizanlagen für Reisezüge, eine Abwurf- und Zuschaltautomatik besitzen, welche beim Rückgang der Oberleitungsspannung die Anlagen abschaltet und erst ca. 3 bis 5 Minuten nach Wiederkehr der Spannung zuschaltet. Diese Vorkehrungen sind erforderlich, damit die Stromaufnahme der Nebenverbraucher das Prüfergebnis der Oberleitungsstreckenprüfung nicht unzulässig beeinträchtigt oder verfälscht.

Die OLPA schaltet bei einem ausgelösten Speiseabzweig selbsttätig den jeweiligen Prüftrenner nach einer kurzen Vorlaufzeit von ein paar Sekunden ein. Somit wird der gesamte Oberleitungsabschnitt mit sämtlichen Speisekabeln und Speiseleitungen sowie bei den auf der Strecke befindlichen elektrischen Triebfahrzeugen einschließlich des gehobenen Stromabnehmers und der Oberspannungsdachausrüstung mit 15-kV-Prüfspannung über eine Prüfdauer von etwa 2 Sekunden beaufschlagt.

Bei "gutem" Prüfergebnis (Entscheidungskriterium ist hierfür die Prüfspannungsauswertung) fließt nur ein geringer Ableitprüfstrom, welcher seinerseits auch einen geringen Spannungsfall am Hochspannungs- (bzw. im Übersetzungsverhältnis des Prüfumspanners - am Niederspannungs-) Prüfwiderstand zur Folge hat, wird durch die OLPA der Prüftrenner ausgeschaltet und anschließend der Abzweig-Leistungsschalter wieder in Betrieb genommen.

Bei "schlechtem Prüfergebnis" fließt durch die noch unzulässigerweise bestehende Erdverbindung ein erhöhter Prüfstrom, welcher aber durch den Prüfwiderstand auf maximal 5 A begrenzt wird. Bei einem Prüfwiderstand von 3,3 kOhm und einer Spannung von 15 kV entsteht unter Umständen eine Verlustleistung von etwa 50 kW, die über die Prüfzeit von 10 Minuten bei Handprüfung eine Energie von etwa 30 MJ im Prüfwiderstand umsetzt. Dementsprechend ist ein derartiger Prüfwiderstand sehr voluminös und aufwendig. Aus diesem Grund wird der Prüfwiderstand nur einmal zentral in einer Schaltanlage für alle Speiseabzweige ausgeführt. Die Prüfzelle ist gegen Kurzschluss und Überhitzung aufwendig zu schützen. Lösen mehrere Speiseabzweige gleichzeitig aus, kann nur nacheinander die Prüfung und Wiederversorgung erfolgen. Auch die in diesem Stand der Technik verwendeten Schalter zum Ein- und Abschalten der Prüfspannung in den Speiseabzweigen sind mechanische Lasttrennschalter und aufwendig angetrieben.

Eine mit der Oberleitungsprüfung vergleichbare Erkennung von Kurzschlüssen auf Leitungsabzweigen elektrischer Drehstromnetze zum Transport oder zur Verteilung von elektrischer Energie vor der Zuschaltung des Hauptstrompfades ist zurzeit noch nicht üblich. In derartigen Freileitungsnetzen treten auch "Kurzschlusswischer" auf. Bei Verfügbarkeit kostengünstiger Verfahren und Vorrichtungen ist auch in Drehstromnetzen eine präventive Prüfung zur Verhinderung des Draufschaltens auf Kurzschlüsse von Vorteil.

Aus der Literatur sind bereits folgende Vorschläge bekannt, Kurzschlüsse auf Leitungsabzweigen vor der Wiedereinschaltung des Leistungsschalters zu erkennen.

EP 0 563 691 und EP 1 192 697 benutzen Halbleiterschalter, die nach Überschreitung einer Prüfstromschwelle im Bereich von unter einer Millisekunde hart abschalten. So wird vor dem Erreichen kritischer Ströme die Prüfung beendet und der Abzweig als kurzschlussbehaftet eingestuft. Diese Verfahren sind in Netzen mit hohen prospektiven Kurzschlussströmen nicht wirtschaftlich anwendbar. Die Halbleiterschalter müssen derart ausgelegt sein, schneller den Strom abzuschalten, als sich dieser in der Kurzschlussmasche weiter aufbauen würde. Die dabei entstehende Abschaltenergie darf das Ausschaltvermögen der Halbleiter nicht überschreiten.
Man könnte zwar daran denken, die Impulsdauer zu verringern, aber das bringt ein anderes Problem mit sich. Vorgeschädigte Betriebsmittel, welche keinen sofortigen Stromanstieg nach Wiedereinschaltung bewirken, sondern erst nach aufgebauter Spannung erneut zünden, werden mit einem kurzen Prüfimpuls nicht erfasst. Weiterhin verhält sich die Kapazität des kurzschlussfreien Speiseabschnitts im Einschaltmoment (Ladestrom) wie ein Kurzschluss und ist somit bei kurzer Impulsdauer nicht von einem kurzschlussbehafteten Abschnitt zu unterscheiden.

Bei diesen Verfahren sind aufwändige Schutzeinrichtungen am Halbleiterschalter zur Begrenzung hoher Induktionsspannungen als Folge der schnellen Stromänderung notwendig. Die einzelnen in Reihe geschalteten Leistungshalbleiter des Halbleiterschalters müssen beim Schaltvorgang extremen Gleichlauf aufweisen. Dies zu realisieren ist sehr aufwändig.

In EP 1 192 697 ist zwar gegenüber EP 0 563 695 ein Prüfwiderstand vorgesehen, der deutlich größer ist als die Netzimpedanz, um den sich aufbauenden Strom zu begrenzen. Zusätzlich zum Halbleiterschalter werden aufwendige und voluminöse Hochspannungsprüfwiderstände zur Strombegrenzung benötigt. Sowohl die Halbleiterschalter, als auch die Prüfwiderstände müssen hochspannungsfest ausgelegt sein. Das verhindert den wirtschaftlichen dezentralen Einsatz im Leitungsabzweig.

Die vorliegende Erfindung geht deshalb von einem anderen Ansatz aus.

Der Stand der Technik bietet heute Halbleiterbauelemente vom Typ MOSFET (metal -oxide - semiconductor field effect transistor), welche im Gegensatz zu beispielsweise Thyristoren, jederzeit voll steuerbar sind. Der positive Temperaturkoeffizient dieser Bausteine verhindert im Übergangsbereich zwischen den Zuständen Ein und Aus die Bildung von sogenannten Hot Spot's. Über die Höhe der Gatespannung kann ein gewünschter Widerstandswert zwischen den Anschlüssen Sorce und Drain eingestellt und über eine Prüfperiode stabil ausgeregelt werden. Dabei wird das Bauelement von einem sekundärseitig angeordneten Treiber im Kleinsignalbereich zwischen den Zuständen Aus und Übergangsbereich ausgesteuert. Zu keiner Zeit wird das Bauelement in der erfindungsgemäßen Anwendung in den Zustand Ein ausgesteuert.

Die nötige Blitzüberspannungsfestigkeit von beispielsweise 145 kV für die Anwendung in der 15kV- Bahnstromversorgung wird durch Reihenschaltung errecht. Das Wechselspannungssteuervermögen ist mittels antiserieller Anordnung mehrerer Bauelemente und durch Verwendung von in den MOSFET's integrierten Freilaufdioden realisierbar. In Feldversuchen an Oberleitungsabzweigen wurde praktisch nachgewiesen, dass es in der Bahnstromanwendung zur sicheren Bewertung eines Speiseabzweiges auf das Vorhandensein eines Kurzschlusses genügt, den Prüfstrom lediglich einen definierten Zeitabschnitt innerhalb nur einer Sinushalbwelle der 16,7Hz Grundschwingung fließen zu lassen. Es kann in derartigen Anwendungen eine einfache unidirektionale Serienanordnung aus steuerbaren Halbleiterwiderständen mit antiseriellen Dioden zur Unterdrückung der nicht benötigten Sinushalbwelle ausreichend sein.

Mit einem derartig steuerbaren Halbleiterwiderstand wird die Möglichkeit geschaffen, den Testlauf ohne einen zusätzlichen strombegrenzenden Prüfwiderstand durchzuführen, weil der gewünschte Prüfwiderstand in der Halbleiteranordnung selbst realisiert wird.

Auch hohe Schaltgeschwindigkeiten, die in seriellen Halbleiterschalteranordnungen etwa zur schnellen Strombegrenzung oder zur Unterdrückung unsymmetrischer Spannungsabfälle über der Reihenschaltung üblich und notwendig sind, werden durch geregeltes Ansteuern der seriellen Halbleiterwiderstände umgangen.

Zur Bewertung des Abzweiges auf Fehlerfreiheit wird vorgeschlagen, nach einer Wartezeit von beispielsweise zwei Sekunden ab einem genau definierten Vorhaltewinkel vor dem Erreichen des Spannungsmaximums der Grundwelle des Spannungsabfalls am hochohmigen Halbleiterwiderstand elektrische Energie in das zu prüfende Netz zu treiben. Zu diesem Zweck wird der steuerbare Halbleiterwiderstand aus seinem hochohmigen Zustand auf einen definierten Widerstandswert von beispielsweise 3 kOhm umgesteuert und bis zum Zeitpunkt der natürlichen Stromumkehr auf diesen Wert ausgeregelt.. Die Geschwindigkeit des Umsteuerns und der Vorhaltewinkel kann an die jeweiligen Netzverhältnisse angepasst werden.

Dabei sollte der Vorhaltewinkel zwischen den Werten 0 Grad und 90 Grad einerseits hinreichend groß gewählt werden, so dass sich am zu prüfenden Netz bei Fehlerfreiheit eine möglichst große Spannung durch Aufladung der Netzkapazität über den eingestellten Prüfwiderstand aufbauen kann. Auch vorgeschädigte Betriebsmittel werden so vom Prüfvorgang sicher als Fehler erkannt. Das Auftreten von Rush-Strömen an unbelasteten Induktivitäten im zu prüfenden Netz wird die Größe des Vorhaltewinkels andererseits begrenzen. Mit größerem Vorhaltewinkel wird allerdings bei Prüfung auf fehlerbehaftete Netze am Halbleiterwiderstand mehr elektrische Energie in Wärme umgesetzt.

Der Wert des empfehlenswerten Vorhaltewinkels hängt von den Gegebenheiten des Leitungsabzweigs ab. Bei Leitungsabzweigen mit hohem kapazitivem Anteil empfehlen sich Vorhaltewinkel von etwa 40 Grad. Meist sind aber bei 15 kV Oberleitungsnetzen Werte von 10 Grad ausreichend.

Kriterium der Fehlerfreiheit ist, dass das von der Anordnung ermittelte Integral des geflossenen Prüfstromes kleiner als eine von der aktuellen Netzspannung abgeleitete Schwelle geblieben ist.

Dieses Verfahren kann mit Halbleiterbauelementen durchgeführt werden, welche nur etwa den einhundertsten Teil des Betriebsstromausschaltvermögens und nur etwa den eintausendsten Teil des Kurzschlussausschaltvermögens des Hauptstrompfades besitzen. Wirtschaftliche Herstellungskosten sind bei Verwendung dieser Bauelemente zu erreichen. Eine derart ausgeführte Anordnung kann zentral pro Schaltanlage sowie aufgrund geringer Herstellungskosten der Anordnung und kompakter Bauweise auch dezentral pro Speiseabzweig direkt parallel zum Leistungsschalterschaltzylinder beispielsweise mit auf dem Schaltwagen angeordnet werden.

Anhand der in den Zeichnungen dargestellten Schaltungen wird die Erfindung näher erläutert. Es zeigen:
- FIG. 1: den Aufbau des Halbleiterwiderstandes in unipolarer Ausführung
- FIG. 2: den Aufbau des Halbleiterwiderstandes in bipolarer Ausführung
- FIG. 3: das Prinzipschaltbild, nach dem die vorliegende Erfindung in zentraler Anordnung arbeitet.
- FIG. 4: das Prinzipschaltbild, nach dem die vorliegende Erfindung in dezentraler Anordnung arbeitet.

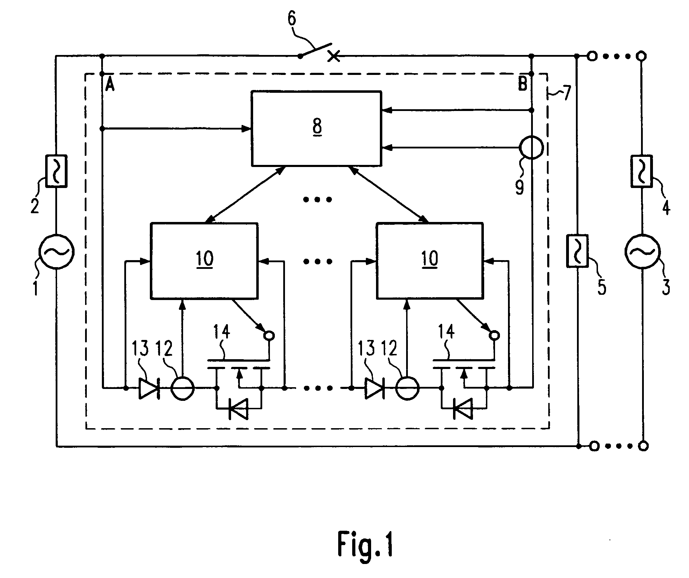

Fig. 1 zeigt den prinzipiellen Aufbau des Halbleiterprüfwiderstands 7 in unipolarer Ausführung mit seinen elektrischen Anschlüssen A und B angeordnet in einem Einphasennetz 1 und dessen Impedanz 2. Auf der rechten Seite dargestellt ist die Impedanz des zu prüfenden Netzabzweiges 5 und über Punkte angedeutet eine möglicherweise vorhandene zweite Einspeisung mit Netz 3 und dessen Impedanz 4. Der Leistungsschalter 6 ist bei Speisung durch Netz 1 eingeschaltet und es werden die Verbraucher im Netzabzweig 5 allein von Netz 1 oder auch parallel zu Netz 3 versorgt.

Im Halbleiterprüfwiderstand befindet sich eine Steuereinheit 8, welche als Messgrößen den Spannungsabfall zwischen den Punkten A und B sowie den Prüfstrom über den Sensor 9 zugeführt bekommt.

Im Prüfstrompfad befinden sich mehrere, in Serie geschaltete Dioden 13, Stromsensoren 12 und MOSFET's 14 denen jeweils eine Treiberschaltung 10 zugeordnet ist. Zwischen der Steuereinheit und den Treiberschaltungen sind bidirektionale potentialtrennende Kommunikationsverbindungen angeordnet. Werden die Treiberschaltungen nicht von der Steuereinheit über die Kommunikationsverbindungen aktiviert, halten diese die Gate- Source- Spannung der MOSFET unterhalb ihrer Schwellenspannung. Alle MOSFET sind in diesem Zustand während der positiven Halbwelle des Spannungsabfalls zwischen den Punkten A und B hochohmig. Die in den MOSFET's integrierten Dioden verhindern Rückspannung an den Transistoren. Während der negativen Halbwelle des Spannungsabfalls sperren die Dioden 13 generell den Prüfstromfluss. Eine nach Fig. 1 ausgeführte Anordnung kann deshalb nur für einen unidirektionalen Prüfstromfluss verwendet werden. Durch Abbruch ist dargestellt, dass möglicherweise weitere seriell geschaltete Bauelemente zur Spannungsfestigkeitserhöhung nötig sind.

Am ausgeschalteten Leistungsschalter 6, fällt über dem Halbleiterprüfwiderstand die Spannungsdifferenz zwischen den Netzen beiderseits des Leistungsschalters ab. Vor einer Zuschaltung des Leistungsschalters wird der Effektivwert dieses Spannungsabfalls von der Steuereinheit einer Schwellenbewertung unterzogen. Ist der Spannungsabfall kleiner als beispielsweise 30 Prozent der Netznennspannung, kann davon ausgegangen werden, dass der Speiseabschnitt von Netz 3 gespeist wird. In diesem Fall ist kein Kurzschluss im Netz 5 vorhanden und der Leistungsschalter kann zugeschaltet werden.

Bei Spannungsabfall oberhalb der Bewertungsschwelle wird zur Verhinderung des Schaltens auf einen möglichen Kurzschluss eine Prüfung notwendig. Hierbei wird die Steuereinheit im ersten Schritt über mehrere Perioden der Grundnetzschwingung den Spannungsabfall über dem Leistungsschalter abtasten, den mittleren Effektivwert aus diesem Spannungsabfall bilden, diesen Wert speichern und den Zeitpunkt des Vorhaltewinkels vor dem Spannungsmaximum zum Ende dieses Schrittes ermitteln.

Zu diesem Zeitpunkt im Verlauf der Grundwelle wird die Steuereinheit im zweiten Schritt allen Treibern 10 zeitgleich das Signal zum Einstellen des definierten Prüfwiderstandswertes aktivieren.

Jedem Treiber 10 werden hierzu die Eingangswerte Spannung über seiner Transistorstufe und der Strom vom Sensor 12 zugeführt. Die Steuerspannung U_{GS} des MOSFET wird vom Treiber soweit ausgeregelt, dass die Spannung den durch das Ohmsche Gesetz bestimmten zum Strom proportionalen Wert annimmt. Hierbei gilt U=I*R bei R=constant.

Mit der Steuerspannung U_{GS} wird daher der gewünschte Widerstand des Drain-Source-Kanals eingestellt. Der Gesamtprüfwiderstand ergibt sich hierbei aus der Summe aller in Reihe angeordneter Drain-Source-Kanalwiderstände. Der Wert des Prüfwiderstandes liegt beispielsweise bei etwa 3kOhm und damit deutlich über der Netzimpedanz. Dabei ergibt sich bei einer Betriebsspannung von 15 kV_{eff} eine Strombegrenzung auf 7 A. Ohne Widerstand würde sich u.U. ein Kurzschlussstrom von 45kA einstellen.

Die Steuereinheit 8 wird die Treiber bis zur Beendigung der Prüfperiode ansteuern und den Strom am Sensor 9 über die Prüfperiode integrieren. Als Prüfperiodendauer wird vorgeschlagen, eine Zeit innerhalb einer Halbwelle der Netzgrundschwingung festzulegen, wobei vorteilhafter Weise mit einem Vorhaltewinkel von >0 Grad und <90 Grad vor dem Spannungsmaximum eingeschaltet und im darauffolgenden natürlichen Stromnulldurchgang abgeschaltet wird. Der Einfluss des kapazitiven Ladestroms des zu prüfenden Netzes auf das Prüfergebnis bei derart langer Prüfdauer wird hinreichend klein. Weiterhin sind die Abschaltströme zum Ende der Prüfperiode bei derart festgelegtem Prüfzeitraum sehr klein, da ohnehin in dieser Zeit der Vorgang der natürlichen Stromumkehr der Grundnetzwelle erfolgt. Nennenswerte induktive Abschaltüberspannungen werden so nicht erst entstehen und es können die Maßnahmen zu dessen Unterdrückung eingespart werden.

Nach Beendigung der Prüfperiode wird die Steuereinheit im dritten Schritt das Stromintegral mit einer vom gespeicherten mittleren Effektivwert des Spannungsabfalls abhängigen Schwelle vergleichen. Der Einfluss der Höhe der Netzspannung auf das Messergebnis Stromintegral ist bei Oberleitungsnetzen nicht vernachlässigbar. Bei höherer Spannung werden sich bei einem konstant eingestellten Prüfwiderstand und bei sonst gleichen Netzverhältnissen ein höherer Prüfstrom und so auch ein höheres Stromintegral über die Prüfperiode einstellen.

Unter der Annahme, dass der Effektivwert des Spannungsabfalls über dem Leistungsschalter unmittelbar vor der Prüfperiode eine hinreichend genaue Aussage der Prüfstromtreibenden Effektivspannungshöhe während der Prüfperiode darstellt wird vorgeschlagen, diesen Effektivwert zur Bildung der Bewertungsschwelle heranzuziehen. Die Bewertungsschwelle wird hierbei direkt proportional aus der gespeicherten Effektivspannungshöhe abgeleitet.

Ist die Schwelle überschritten, wird das Netz 5 als kurzschlussbehaftet eingestuft und das Einschalten des Leistungsschalters 6 verhindert.

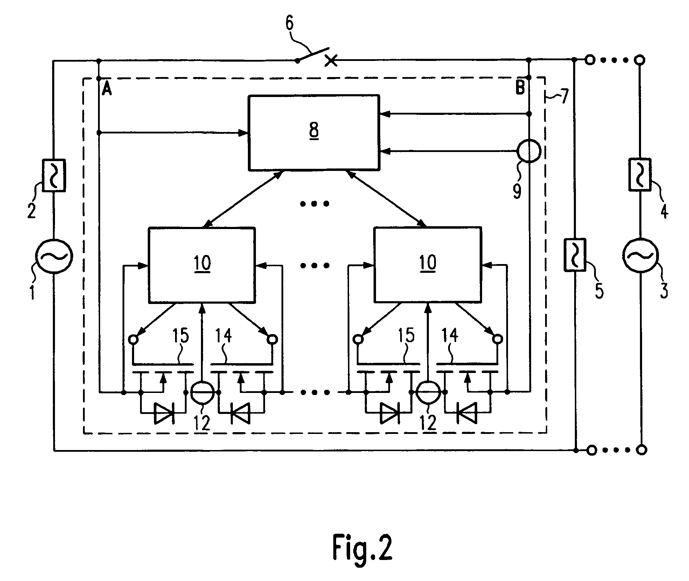

Fig. 2 zeigt den prinzipiellen Aufbau des Halbleiterprüfwiderstands 7 in bipolarer Ausführung. Die Darstellung entspricht der nach Fig.1, jedoch wurden die Dioden 13 durch MOSFET's 15 ersetzt. Diese werden analog MOSFET 14 in der negativen Halbwelle des Spannungsabfalls am Halbleiterprüfwiderstand wirksam. So kann die Prüfperiode auch in der negativen Halbwelle ausgeführt werden, wenn dies im Ausnahmefall erforderlich sein sollte. Bei Anwendung in Drehstromnetzen wird für jede Phase des Netzes ein separater Halbleiterprüfwiderstand benötigt. Dabei wird in einer der drei Phasen ein bipolar ausgeführter Halbleiterprüfwiderstand notwendig sein. In den beiden anderen genügt die unipolare Ausführung. Es werden drei Prüfungen nacheinander notwendig, um alle verschiedenen Netzfehler diskriminieren zu können. In zwei Phasen wird dazu jeweils gleichzeitig eine Prüfperiode angeregt.

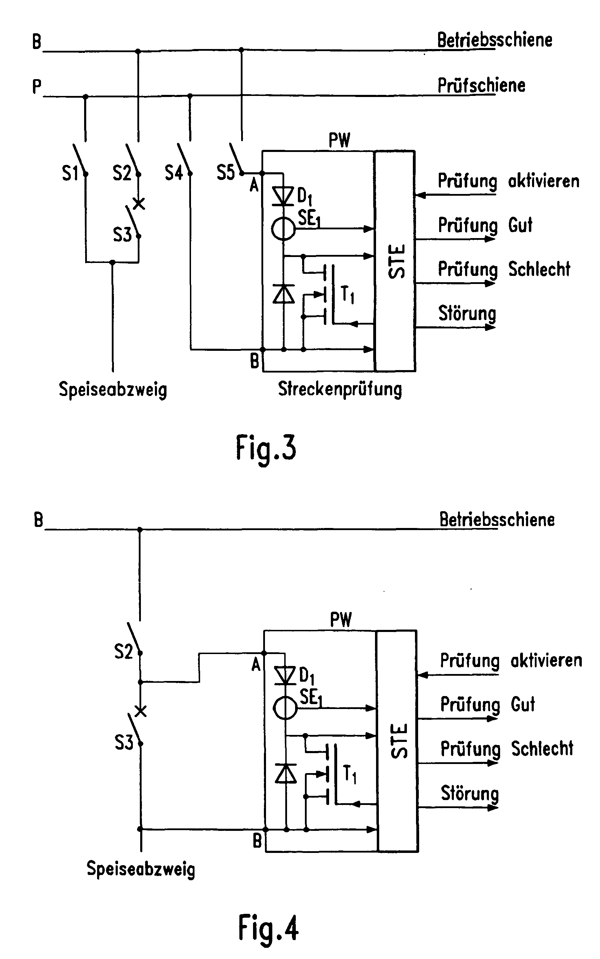

Fig. 3 zeigt eine Betriebsschiene B und eine Prüfschiene P. Auf der Betriebsschiene B liegt üblicherweise bei 16,7Hz Oberleitungsversorgungsnetzen eine Effektivspannung von 15 kV. Im Normalbetrieb ist der Speiseabzweig über die Schalter S2 und S3 mit der Betriebsschiene B verbunden. Über eine nicht dargestellte Schutzeinrichtung wird der Leistungsschalter S3 im Kurzschluss- oder Überlastfall ausgelöst, so dass der Speiseabzweig von dieser Schaltanlage nicht mehr versorgt wird.

Parallel zur Betriebsschiene B befindet sich eine Prüfschiene P, auf die eine elektrische Prüfenergie von der Betriebsschiene zum Testen auf Kurzschluss über den Schalter S5, den steuerbaren Halbleiterprüfwiderstand PW, sowie über den Schalter S4 aufgebracht werden kann. Zum Zweck der Prüfung eines Speiseabzweiges wird dieser mit Schalter S1 an die Prüfschiene geschaltet. Der Halbleiterprüfwiderstand ist im dargestellten Fall mit einem antiseriell zur Diode D1 verschalteten Transistor T1 mit integrierter Freilaufdiode aufgebaut, welcher von einer Steuereinheit STE ansteuerbar ist. Der dargestellte Stromsensor SE1 und der Spannungsabgriff über dem Transistor stellt der Steuereinheit die zur Regelung des Widerstandes nötigen Werte bereit. In Figur 1 nicht dargestellt ist die zur Erreichung der Spannungsfestigkeit notwendige Serienschalung mehrerer Elemente bestehend aus D1, T1 und SE1. Die Steuereinheit STE enthält entsprechende potentialfreie Treiberschaltungen zum Ansteuern der Halbleitertransistorelemente im Widerstandsbereich.

Die Schalter S2, S4, S5 sind im Normalbetrieb und während des gesamten Testlaufs geschlossen.

Eine Voraussetzung zum Start des Testlaufs ist der ausgelöste oder ausgeschaltete Leistungsschalter S3. Zum Betätigen des Testlaufes wird zunächst der Schalter S1 eingeschaltet, um den Speiseabzweig mit der Prüfschiene zu verbinden. Der Halbleiterwiderstand T1 ist noch hochohmig. Durch ein der Steuereinheit STE zugeführtes Startsignal "Prüfung aktivieren" wird die in der Steuereinheit enthaltene Treiberschaltung aktiviert, die den Halbleiterwiderstand (T1) eine Prüfperiode lang und mit dem Spannungsverlauf am Prüfwiderstand synchronisiert auf einen definierten Widerstandswert regelt. Der über den Prüfwiderstand fließende Prüfstrom wird über die Strommessung SE1 erfasst und der Steuereinheit STE zugeführt. Die Strommesswerte werden über die gesamte Prüfperiode von der Steuereinheit integriert.
Dieses Stromintegral wird zur Auswertung mit einem zu der Höhe des Spannungseffektivwertes der Netzspannung proportionalen Schwellwert verglichen. Bei Überschreitung des Schwellwertes, ist das Prüfergebnis negativ. Die Steuereinheit setzt den Ausgang "Prüfung schlecht". Der Schalter S1 wird ausgeschaltet. Der betroffene Speiseabzweig bleibt spannungslos und die Streckenprüfung steht für alle Speiseabzweige für weitere Prüfungen erneut zur Verfügung.

Ohne vorhandenen Kurzschluss entstehen bei den üblicherweise abgeworfenen Lasten, wie Triebfahrzeugen und Weichenheizungen keine nennenswerten Ströme. Das Stromintegral wird unter der festgelegten Schwelle bleiben und das Prüfergebnis ist positiv. Es wird dann von der Steuereinheit das Signal "Prüfung gut" gesetzt und in Folge der Schalter S1 ausgeschaltet. Durch Zuschaltung des Leistungsschalters S3 ist der Normalschaltzustand zur Wiederversorgung des Streckenabzweiges erreicht. Eine nicht im Einzelnen dargestellte Selbstüberwachung überprüft alle funktionswichtigen Größen der Anordnung. Bei unzulässigen Abweichungen der Werte wird der Ausgang "Störung" gesetzt und das Zuschalten des Leistungsschalters wird gesperrt.

Fig. 4 zeigt die Möglichkeit der dezentralen Anordnung. Es wird in jedem Speiseabzweig ein Halbleiterprüfwiderstand PW vorgesehen. Im Vergleich zur zentralen Anordnung kann die gesamte Prüfschienenanordnung und das Streckenprüfschaltfeld entfallen. Die gleichzeitige Prüfung mehrerer Abzweige verkürzt die Versorgungsunterbrechungszeiten wesentlich. Die Verfügbarkeit der Prüfung in der Gesamtschaltanlage wird erhöht.

Im Normalbetrieb sind die Schalter S2 und S3 geschlossen und der Halbleiterprüfwiderstand PW ist hochohmig.

Der Halbleiterprüfwiderstand ist im dargestellten Fall mit einem antiseriell zur Diode D1 verschalteten Transistor T1 mit integrierter Freilaufdiode aufgebaut, welcher von einer Steuereinheit STE ansteuerbar ist. Der dargestellte Stromsensor SE1 und der Spannungsabgriff über dem Transistor stellt der Steuereinheit die zur Regelung des Widerstandes nötigen Werte bereit. In Figur 2 nicht dargestellt ist die zur Erreichung der Spannungsfestigkeit notwendige Serienschalung mehrerer Elemente bestehend aus D1, T1 und SE1. Die Steuereinheit STE enthält entsprechende potentialfreie Treiberschaltungen zum Ansteuern der Halbleitertransistorelemente im Widerstandsbereich.

Der Schalter S2 ist im Normalbetrieb und während des gesamten Testlaufs geschlossen.

Eine Voraussetzung zum Start des Testlaufs ist der ausgelöste oder ausgeschaltete Leistungsschalter S3. Der Halbleiterwiderstand T1 ist noch hochohmig. Durch ein der Steuereinheit STE zugeführtes Startsignal "Prüfung aktivieren" wird die in der Steuereinheit enthaltene Treiberschaltung aktiviert, die den Halbleiterwiderstand (T1) eine Prüfperiode lang und mit dem Spannungsverlauf am Prüfwiderstand synchronisiert auf einen definierten Widerstandswert regelt. Der über den Prüfwiderstand fließende Prüfstrom wird über die Strommessung SE1 erfasst und der Steuereinheit STE zugeführt. Die Strommesswerte werden über die gesamte Prüfperiode von der Steuereinheit integriert.

Dieses Stromintegral wird zur Auswertung mit einem zu der Höhe des Spannungseffektivwertes der Netzspannung proportionalen Schwellwert verglichen. Bei Überschreitung des Schwellwertes, ist das Prüfergebnis negativ. Die Steuereinheit setzt den Ausgang "Prüfung schlecht". Der betroffene Speiseabzweig bleibt spannungslos.

Ohne vorhandenen Kurzschluss entstehen bei den üblicherweise abgeworfenen Lasten, wie Triebfahrzeugen und Weichenheizungen keine nennenswerten Ströme. Das Stromintegral wird unter der Schwelle bleiben und das Prüfergebnis ist positiv. Es wird dann von der Steuereinheit das Signal "Prüfung gut" gesetzt. Durch Zuschaltung des Leistungsschalters S3 ist der Normalschaltzustand zur Wiederversorgung des Streckenabzweiges erreicht.

Eine nicht im Einzelnen dargestellte Selbstüberwachung überprüft alle funktionswichtigen Größen der Anordnung. Bei unzulässigen Abweichungen der Werte wird der Ausgang "Störung" gesetzt und das Zuschalten des Leistungsschalters wird gesperrt.

## Patentansprüche

1. Verfahren zur Erkennung von Kurzschlüssen auf ausgeschalteten Leitungsabzweigen von elektrischen Wechsel- oder Drehstromnetzen, bei-denen der zu prüfende Leitungsabzweig im Prüffall mit Betriebsenergie beaufschlagt wird und der sich dabei aufbauende Strom unter Einsatz eines Prüfwiderstandes, der wesentlich größer als der Leitungswiderstand des Leitungsabzweigs bemessen ist, bewertet wird,
dass das Zuschalten der Betriebsenergie über einen steuerbaren Halbleiterschalter erfolgt,
**dadurch gekennzeichnet, dass** das Aufschalten von Betriebsenergie zu einem definierten Zeitpunkt der Sinusgrundwelle des Spannungsabfalls am Halbleiterschalter, vorzugsweise mit einem Vorhaltewinkel von >0 Grad und <90 Grad vor dem Spannungsmaximum, erfolgt,
dass das Abschalten der Betriebsenergie im darauffolgenden natürlichen Nulldurchgang des Prüfstromes erfolgt,
dass als Halbleiterschalter ein MOSFET-Halbleiter benutzt wird,
und dass der Prüfwiderstand im MOSFET-Halbleiterschalter durch entsprechende Ansteuerung seiner Source- Drain-Spannung erzeugt wird.

2. Verfahren nach Anspruch 1, **dadurch gekennzeichnet, dass** zur Bewertung des Stroms das Stromintegral über dem Prüfzeitraum herangezogen und mit einer von der Höhe der Netzspannung direkt proportionalen Schwelle verglichen wird.

3. Verfahren nach Anspruch 1 oder 2, **dadurch gekennzeichnet, dass** zum Erreichen der notwendigen Spannungsfestigkeit und Wärmekapazität mehrere Halbleiterschalter in Reihe geschaltet sind, die parallel angesteuert werden, um in der Summe den gewünschten Prüfwiderstand zu liefern.

## Claims

1. Method of detecting short-circuits on disconnected circuit branches of electric alternating current or three-phase supply networks, whereby, when a test is run, operating power is applied to the circuit branch to be tested and the current generated as a result is evaluated on the basis of a test resistance which is significantly higher than the power supply impedance of the circuit branch,
the operating power being connected via a controllable semiconductor switch,
**characterised in that** operating power is connected up to a defined instant of the basic sine wave of the voltage drop at the semiconductor switch, preferably with a leading angle of >0 degrees and <90 degrees before the voltage maximum,
the operating power is disconnected when the test current next naturally passes through zero,
a MOSFET semiconductor is used as the semiconductor switch
and the test resistance in the MOSFET semiconductor switch is generated by activating its source-drain voltage accordingly.

2. Method as claimed in claim 1, **characterised in that,** in order to evaluate the current, the current integral is applied during the test period and compared with a threshold directly proportional to the level of the network voltage.

3. Method as claimed in claim 1 or 2, **characterised in that**, in order to achieve the requisite dielectric strength and heat capacity, several semiconductor switches are connected in series and activated in parallel so that, in total, they supply the desired test resistance.

## Revendications

1. Procédé pour détecter des courts-circuits sur des lignes de dérivation déconnectées de réseaux électriques de courant alternatif ou triphasé dans lesquels la ligne de dérivation à contrôler est sollicitée en cas de contrôle avec une énergie de fonctionnement et le courant qui apparaît alors est évalué à l'aide d'une résistance de contrôle qui est nettement supérieure à la résistance de la ligne de dérivation, et la mise en circuit de l'énergie de fonctionnement se fait par l'intermédiaire d'un commutateur à semi-conducteur apte à être commandé,
**caractérisé en ce que** l'amenée d'énergie de fonctionnement a lieu à un moment défini de l'onde fondamentale sinusoïdale de la baisse de tension sur le commutateur à semi-conducteur, de préférence avec un angle de dérivation >0 degré et <90 degrés avant le maximum de tension,
**en ce que** l'arrêt de l'énergie de fonctionnement a lieu lors du passage par zéro naturel consécutif du courant de contrôle,
**en ce qu'**on utilise comme commutateur à semi-conducteur un MOSFET,
et **en ce que** la résistance de contrôle dans le commutateur MOSFET est produite grâce à une commande correspondante de sa tension source-drain.

2. Procédé selon la revendication 1, **caractérisé en ce que** pour l'évaluation du courant, l'intégrale de courant est utilisée pendant la durée de contrôle et est comparée à un seuil qui est directement proportionnel à la hauteur de la tension de réseau.

3. Procédé selon la revendication 1 ou 2, **caractérisé en ce que** pour obtenir la rigidité diélectrique et la capacité thermique souhaitées, on monte en série plusieurs commutateurs à semi-conducteur qui sont commandés en parallèle, afin de fournir dans la somme la résistance de contrôle souhaitée.
